# EUROPEAN PATENT SPECIFICATION

(11) **EP 0 498 893 B1**
(45) Date of publication and mention of the grant of the patent: **05.02.1997**
(21) Application number: 91915270.2
(22) Date of filing: 02.09.1991
(51) Int. Cl.: H01P 1/16

(54) **MICROWAVE MULTI-STAGE AMPLIFIER**
MEHRSTUFIGER MIKROWELLENVERSTÄRKER
AMPLIFICATEUR HYPERFREQUENCE A PLUSIEURS ETAGES

(30) Priority: 03.09.1990 JP 233501/90
(43) Date of publication of application: 19.08.1992
(73) Proprietor: MATSUSHITA ELECTRIC INDUSTRIAL CO., LTD., Kadoma-shi, Osaka-fu, 571 (JP)
(72) Inventor: DEKI, Akihito, Amagasaki-shi, Hyogo 661 (JP); KASHIMA, Yukiro, Takatsuki-shi, Osaka 569 (JP); FUJISAKI, Hirotaka, Neyagawa-shi, Osaka 572 (JP)
(74) Representative: Sorrell, Terence Gordon
(86) International application number: PCT/JP91/01172
(87) International publication number: WO 92/04743

(56) References cited:
- JP-A- 1 314 408
- JP-A-50 139 653
- JP-U-59 174 701
- PATENT ABSTRACTS OF JAPAN vol. 13, no. 136 (E-737)5 April 1989 & JP-A-63 300 597

## Description

The present invention relates to a microwave multistage amplifier used in a microwave communication system or the like.

Recently, microwave multistage amplifiers used in microwave communication systems are required to have significantly high stability essentially free from abnormal oscillations which may possibly be caused by an environmental condition or a condition of any other device connected to this amplifier. Solid-state elements such as HEMT, MES-FET or the like recently employed in the band range of microwaves have high power gain, and when a microwave multistage amplifier is constructed using such solid-state elements and there is not sufficient spatial isolation between the input terminal and the output terminal of the multistage amplifier, there is a danger of causing abnormal oscillations of the multistage amplifier.

Referring to the attached drawings, a conventional microwave multistage amplifier of the abovementioned type will be described below.

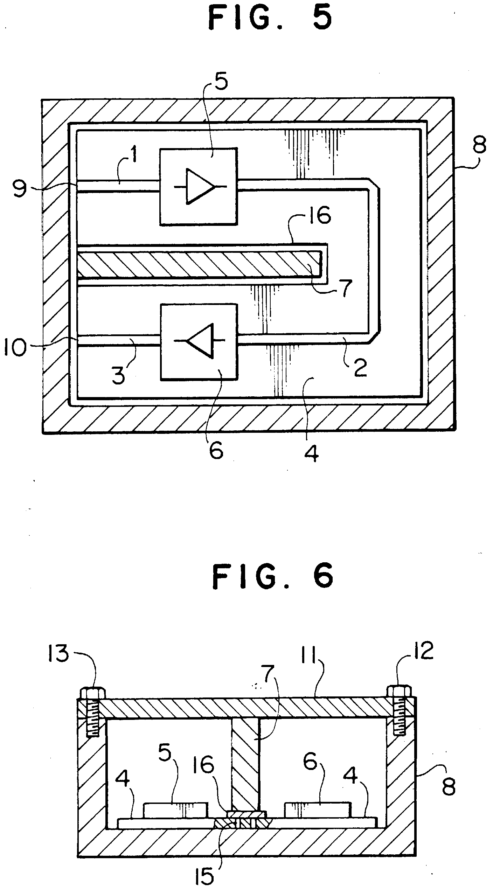

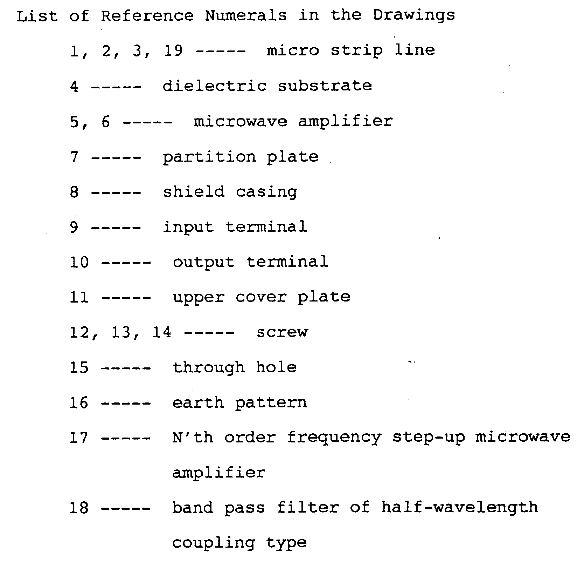

Fig. 5 shows a known microwave multistage amplifier, and Fig. 6 is a sectional view thereof. In Figs. 5 and 6, numerals 1, 2 and 3 denote micro strip lines, and numeral 4 denotes a dielectric substrate upon which a microwave circuit can be formed. A microwave signal input through an input terminal 9 is sequentially amplified by microwave amplifiers 5 and 6, and then is output through an output terminal 10. The microwave signal amplified by the microwave amplifier 6 has a potential level higher than that of the microwave signal input through the input terminal 9. Therefore, under certain conditions relating to the permittivity or the thickness of the dielectric substrate, the microwave signal output from the microwave amplifier 6 can possibly be transmitted to the micro strip line 1 as a surface wave mode propagated signal, thereby causing an abnormal oscillation of the multistage amplifier.

In order to prevent the abovementioned adverse phenomenon, it is necessary to spatially isolate the input side and the output side of the microwave multistage amplifier. In detail, there are provided a partition plate 7 which is screwed or soldered to an earth member 16 mounted on the dielectric substrate 4 by means of a through hole 15 and an upper cover plate 11 which is fixed to the shield casing 8 by means of screws 12 and 13 to close the opening of the casing 8.

In the abovementioned structure, however, the upper cover plate 11 cannot be screwed to the partition plate 7, because this screwing causes a deformation of the dielectric substrate 4 and, as a result, a cracking of the earth member 16. Consequently, a gap remains between the upper cover plate 11 and the partition plate 7, which results in a deterioration of the spatial isolation between the partitioned rooms in the casing.

Further, a problem exists in that a microwave can be transmitted through the dielectric substrate 4 as a surface wave mode propagated signal, excluding a TEM mode, from one room of the casing to be transferred to the micro strip line 1 in the other room of the casing, thereby also resulting in a deterioration of the spatial isolation.

Japanese specification JP-U-59-174701 describes a microwave circuit device including a partition plate for spatially isolating parts of the microwave circuit. This device includes a cover plate for closing an opening of the device. The cover plate comprises an auxiliary cover plate formed of a corrugated electroconductive material for closing a portion of the opening of the device and a main cover plate for closing the opening of the device. The auxiliary cover plate is in electrical contact with the main plate and is connected to the partition plate by electroconductive adhesive. This is a complex arrangement which relies on the quality of the adhesive bond holding the auxiliary cover plate in position.

The object of the present invention is to overcome the abovementioned problems, and to provide a microwave multistage amplifier having excellent operational stability, in which any deterioration in spatial isolation due to the generation of a surface wave mode propagated wave transmitted through the dielectric substrate is prevented by strictly separating the rooms in the casing from each other.

To solve the abovementioned problems, a microwave multistage amplifier according to the present invention comprises a microwave multistage amplifier, comprising: a shield casing for accommodating a microwave multistage amplifier; a partition plate moulded integrally with said casing, said partition plate dividing a dielectric substrate arranged within the casing; a multistage amplifier consisting of at least two microwave elements including at least one amplifier, said multistage amplifier being arranged on the dielectric substrate such that the at least one amplifier is arranged separately from the other microwave element(s) with the partition plate disposed therebetween; and an upper cover plate for closing an opening of the casing, characterised in that the upper cover plate is screwed directly to the casing and also screwed directly to the partition plate.

By virtue of the abovementioned structure according to the present invention, the rooms in the casing are strictly separated from each other and the surface wave mode of microwave propagation in the dielectric substrate is suppressed, thereby assuring a strict isolation among the microwave elements.

The features of the invention will be better understood from the following description, with reference to the drawings, of which:-
Fig. 1 is a plan view of a microwave multistage amplifier according to an embodiment of the present invention;
Fig. 2 is a sectional view of the important portion of the amplifier shown in Fig. 1;
Fig. 3 is a plan view of a microwave amplifier of N'th order frequency multiplier according to another embodiment of the present invention;
Fig. 4 is a sectional view of the important portion of the amplifier shown in Fig. 3;
Fig. 5 is a plan view of a conventional microwave multistage amplifier; and
Fig. 6 is a sectional view of the important portion of the amplifier shown in Fig. 5.

Referring to the attached drawings, a microwave multistage amplifier according to an embodiment of the present invention will be described below.

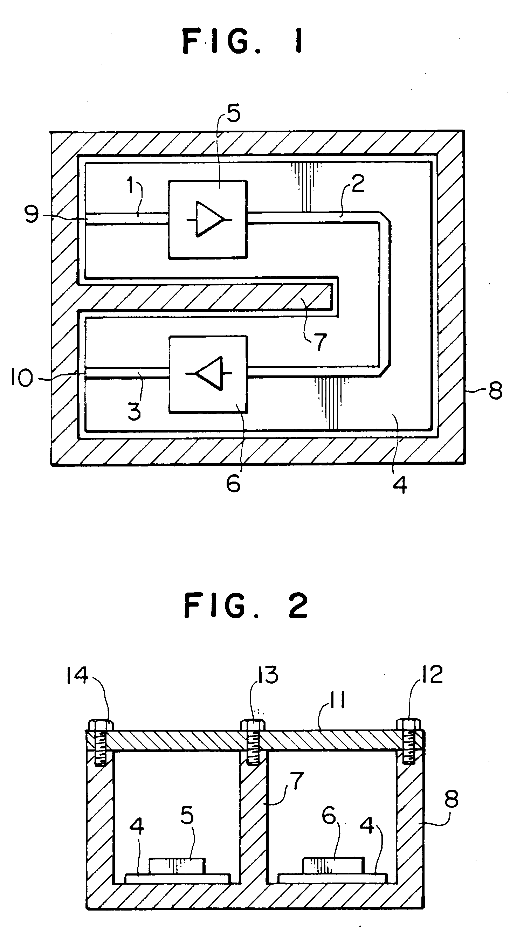

Fig. 1 shows a microwave multistage amplifier, and Fig. 2 is a sectional view of the same amplifier.

In Figs. 1 and 2, numerals 1, 2 and 3 denote micro strip lines, and numeral 4 a dielectric substrate for forming a microwave circuit. A microwave signal input through an input terminal 9 is successively amplified by microwave amplifier 5 and then microwave amplifier 6 and output through an output terminal 10. Since the dielectric substrate 4 is divided by a partition plate 7 constructed integrally with a shield casing 8, a surface wave mode propagated signal on the dielectric substrate 4 is prevented and no electrical connection occurs between the micro strip lines 1 and 3. Further, since an upper plate 11 is directly screwed to the partition plate 7 and the casing 8 by means of screws 12, 13 and 14, respectively, the two rooms as shown in Fig. 2 are completely separated from each other by three conductive members, namely, the shield case 8 the upper cover plate 11 and the partition plate 7.

According to the abovementioned embodiment, by integrally moulding the partition plate 7 with the shield casing 8 and screwing the upper cover plate 11 to the partition plate 7, the rooms in the casing can be spatially separated from each other, thereby suppressing the surface wave mode propagated signal on the dielectric substrate 4 and making it possible to provide a stable microwave multistage amplifier having a superior isolation characteristic.

Next, another embodiment of the present invention will be described below by referring to the attached drawings.

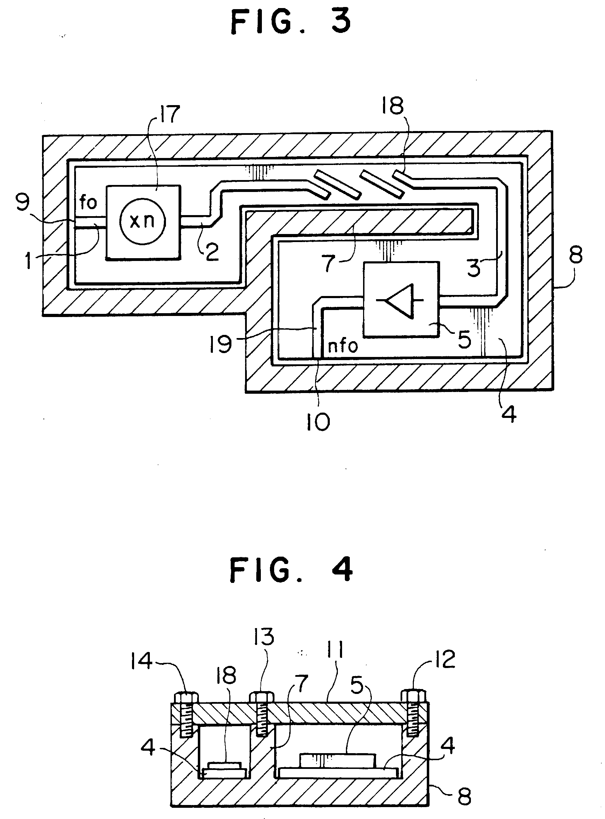

Fig. 3 is a plan view of a microwave frequency n-th order multiplier according to another embodiment of the present invention. Fig. 4 is a sectional view of the multiplier of Fig. 3.

In Figs. 3 and 4, numerals 1, 2, 3 and 19 denote micro strip lines provided on a dielectric substrate 4. A microwave signal at a frequency, input through an input terminal 9 is transformed into a microwave including harmonics by a microwave frequency n-th order multiplier 17, and the N'th order harmonic of frequency nf_{c} is separated by means of a band-pass filter 18 of half-wavelength coupling type. Then, for raising the potential level of the higher harmonic nfₒ, the harmonic is amplified by the microwave amplifier 5 and then, output through an output terminal 10 as a microwave of frequency nfₒ.

Especially, in a frequency multiplier, there are generated a plurality of harmonics each having a frequency defined by multiplying the original frequency fₒ by an integer. It is necessary to adequately remove the harmonics other than that of frequency nfₒ. According to the abovementioned embodiment of the present invention, it is possible to spatially separate the rooms in the casing from each other by providing a partition plate 7 moulded integrally with a shield casing 8 and screwing an upper cover plate 11 to the partition plate 7 and the shield casing 8 by use of screws 12, 13 and 14, respectively, thereby making it possible to ensure a sufficient isolation between the rooms. Further, by suitably selecting the distance between the partition plate 7 and each of the side walls of the shield casing 8 and the height from the bottom of the shield casing 8 to the upper cover plate 11 at the region where the band-pass filter 18 of a half-wavelength coupling type is located for the purpose of utilising a cut-off mode of a rectangular waveguide, it is possible to decrease the microwave power loss in the propagating microwave through this region and to enhance the capability of removing undesired harmonics.

## Claims

1. A microwave multistage amplifier, comprising: a shield casing (8) for accommodating a microwave multistage amplifier; a partition plate (7) moulded integrally with said casing (8), said partition plate (7) dividing a dielectric substrate (4) arranged within the casing (8); a multistage amplifier consisting of at least two microwave elements (5,6; 17,18,5) including at least one amplifier (5), said multistage amplifier being arranged on the dielectric substrate (4) such that the at least one amplifier (5) is arranged separately from the other microwave element(s) (6; 17,18) with the partition plate (7) disposed therebetween; and an upper cover plate (11) for closing an opening of the casing (8), characterised in that the upper cover plate (11) is screwed directly to the casing (8) and also screwed directly to the partition plate (7).

## Patentansprüche

1. Mehrstufiger Mikrowellenverstärker mit: einem Abschirmgehäuse (8) zum Aufnehmen eines mehrstufigen Mikrowellenverstärkers, einer einstückig mit dem Gehäuse (8) geformten Unterteilungsplatte (7), wobei die Unterteilungsplatte (7) ein in dem Gehäuse (8) angeordnetes dielektrisches Substrat (4) unterteilt, einem aus mindestens zwei mindestens einen Verstärker (5) enthaltenden Mikrowellenelementen (5, 6; 17, 18, 5) bestehenden mehrstufigen Verstärker, wobei der mehrstufige Verstärker so auf dem dielektrischen Substrat (4) angeordnet ist, daß der mindestens eine Verstärker (5) von dem (den) anderen Mikrowellenelement(en) (6; 17, 18) durch die dazwischen angeordnete Unterteilungsplatte (7) getrennt ist, und einer oberen Abdeckplatte (11) zum Abschließen einer Öffnung des Gehäuses (8), dadurch gekennzeichnet, daß die obere Abdeckplatte (11) direkt an das Gehäuse (8) und auch direkt an die Unterteilungsplatte (7) geschraubt ist.

## Revendications

1. Amplificateur hyperfréquence à plusieurs étages, comprenant : un boîtier de blindage (8) destiné à loger un amplificateur hyperfréquence à plusieurs étages ; une cloison de séparation (7) moulée d'un seul tenant avec ledit boîtier (8), ladite cloison de séparation (7) divisant un substrat isolant (4) disposé à l'intérieur du boîtier (8) ; un amplificateur à plusieurs étages composé d'au moins deux éléments hyperfréquences (5,6 ; 17,18,5) incluant au moins un amplificateur (5), ledit amplificateur à plusieurs étages étant disposé sur le substrat isolant (4) de telle façon que l'amplificateur (5), prévu en au moins un exemplaire, soit séparé du ou des autres éléments hyperfréquences (6; 17,18) par la cloison de séparation (7) disposée entre eux ; et une plaque supérieure de recouvrement (11) destinée à fermer une ouverture du boîtier (8), caractérisé en ce que la plaque supérieure de recouvrement (11) est vissée directement sur le boîtier (8) et également vissée directement sur la cloison de séparation (7).
